# EUROPEAN PATENT SPECIFICATION

(11) **EP 3 993 029 B1**
(45) Date of publication and mention of the grant of the patent: **04.03.2026**
(21) Application number: 20835601.4
(22) Date of filing: 22.04.2020
(51) Int. Cl.: G02F 1/13357, H01L 25/075, H10H 20/857

(54) **LIGHT-EMITTING MODULE HAVING PLURALITY OF LIGHT-EMITTING DIODE CHIPS CONNECTED IN SERIES AND PARALLEL**
LICHTEMITTIERENDES MODUL MIT EINER VIELZAHL VON IN REIHE ODER PARALLEL VERBUNDENEN LEUCHTDIODENCHIPS
MODULE ÉLECTROLUMINESCENT COMPRENANT UNE PLURALITÉ DE PUCES DE DIODES ÉLECTROLUMINESCENTES CONNECTÉES EN SÉRIE ET EN PARALLÈLE

(30) Priority: 04.07.2019 KR 20190080953
(43) Date of publication of application: 04.05.2022
(73) Proprietor: Seoul Semiconductor Co., Ltd., Gyeonggi-do 15429 (KR)
(72) Inventor: YEO, Seung Yong, Ansan-Si Gyeonggi-do 15429 (KR); CHUNG, Tae Jin, Ansan-Si Gyeonggi-do 15429 (KR); WANG, Jingxian, Ansan-Si Gyeonggi-do 15429 (KR); WANG, Pengfei, Ansan-Si Gyeonggi-do 15429 (KR)
(74) Representative: Isarpatent
(86) International application number: PCT/KR2020/005325
(87) International publication number: WO 2021/002573

(56) References cited:
- GB-A- 2 453 423
- JP-A- 2015 119 096
- KR-A- 20110 033 965
- KR-A- 20140 077 574
- KR-A- 20140 147 310
- US-A1- 2009 091 947
- US-A1- 2009 190 330
- US-A1- 2016 069 546

## Description

### [TECHNICAL FIELD]

Exemplary embodiments of the present disclosure relate to a light emitting module, and more particularly, to a light emitting module having a plurality of light emitting diode chips connected in series-parallel.

### [Background Art]

A light emitting diode has been used as a light source for providing uniform planar light in a liquid crystal display or general lighting apparatus.

In particular, a light emitting module used as a light source for a large-area liquid crystal display or a flat panel includes a significant number of light emitting diode chips arranged on a circuit board so as to provide uniform planar light.

Meanwhile, the light emitting diode chip generally has a forward voltage of 5V or less. For this reason, it is necessary to use a plurality of light emitting diode chips connected in series so as to drive a backlight unit using a high voltage power source, for example, a household power source such as 110V or 220V. Furthermore, in order to simplify a driving circuit, a series-parallel structure in which the light emitting diode chips are connected in series and in parallel is employed.

The series-parallel structure has an advantage in that the driving circuit can be simplified because a large number of light emitting diode chips can be driven under a specific driving voltage at the same time. However, when the forward voltage difference occurs between strings connected in series, there is a drawback in that non-uniform planar light is generated. For this reason, since the light emitting diode chips to be mounted on the light emitting module need to be selected so as to have a same forward voltage as one another, a production yield of the

Moreover, as an operating time of the display or the lighting apparatus increases, a performance change occurs in the light emitting diode chips, and the performance change is not uniform among the light emitting diode chips. The performance change of the light emitting diode chips may cause forward voltage differences between the strings, and accordingly, uniform planar light may not be provided.

US 2009/091947 A1 provides a surface light source structure having a circuit board, a first light emitting diode (LED) array, and a second LED array. US 2009/190330 A1 provides a light source assembly that may facilitate the coupling and the replacement of light source units, and may thus reduce the manufacturing time, and a liquid crystal display (LCD) having the same. GB 2 453 423 A provides a device comprising a substrate 10 and light emitting devices arranged in a linear array and having separate power supply paths to separate groups of LEDs within the array.

### [Disclosure]

### [Technical Problem]

An object of the present disclosure is to provide a light emitting module capable of providing uniform planar light for a long time while a series-parallel connection structure is employed.

### [Technical Solution]

The present invention is set out by the appended claims.

A light emitting module according to the present invention is provided, as defined by independent claim 1. The light emitting module according to the present invention includes: light emitting diode chips arranged in a plurality of regions on a circuit board, in which the light emitting diode chips are divided into a plurality of light emitting diode groups, the light emitting diode chips belonging to a same light emitting diode group are connected in series, the plurality of light emitting diode groups is connected in parallel to one another, and at least one of the light emitting diode chips in each of the plurality of light emitting diode groups is disposed in a region different from that of at least one other light emitting diode chip of the corresponding light emitting diode group of the plurality of light emitting diode groups. The light emitting diode chips are arranged such that three or more light emitting diode chips of a same light emitting diode group are not continuously arranged in any direction.

A light emitting module according to the present invention is provided, as defined by independent claim 13. The light emitting module according to the present invention includes: a circuit board; and light emitting diode chips arranged on the circuit board, in which the light emitting diode chips include a first group of light emitting diode chips connected in series with one another and a second group of light emitting diode chips connected in series with one another, the first group of light emitting diode chips and the second group of light emitting diode chips are connected in parallel to one another, and when the circuit board is equally divided into four, each divided region includes at least one light emitting diode chip of the first group and at least one light emitting diode chip of the second group.

### [Advantageous Effects]

According to exemplary embodiments of the present disclosure, since light emitting diode chips of each group connected in series are divided on a circuit board, even when a failure occurs in the light emitting diode chips of any one group, uniform planar light may be provided.

Other advantages and features of the present disclosure will be clearly understood from the detailed description given below.

### [Brief Description of Drawings]

FIG. 1 is a schematic plan view illustrating a light emitting module according to a prior art.
FIG. 2 is a schematic circuit diagram of the light emitting module of FIG. 1.
FIG. 3 is an image illustrating a failure of light emitting pattern of the light emitting module according to the prior art.
FIG. 4 is a schematic plan view illustrating a display apparatus according to an exemplary embodiment of the present disclosure.
FIG. 5 is a schematic plan view illustrating a light emitting module according to an exemplary embodiment of the present disclosure.
FIG. 6 is a schematic circuit diagram of the light emitting module of FIG. 5.
FIGS. 7A and 7B are a schematic cross-sectional view and a circuit diagram illustrating a light emitting diode chip arranged in the light emitting module according to an exemplary embodiment of the present disclosure, respectively.
FIGS. 8A and 8B are a schematic cross-sectional view and a circuit diagram illustrating a light emitting diode chip arranged in a light emitting module according to another exemplary embodiment of the present disclosure, respectively.
FIG. 9 is an image illustrating a failure of light emitting pattern of the light emitting module according to an exemplary embodiment of the present disclosure.
FIG. 10 is a schematic plan view illustrating a light emitting module.

### [Best Mode]

Hereinafter, exemplary embodiments of the present disclosure will be described in detail with reference to the accompanying drawings. The following embodiments are provided by way of example so as to fully convey the spirit of the present disclosure to those skilled in the art to which the present disclosure pertains. Accordingly, the present disclosure is not limited to the embodiments disclosed herein and can also be implemented in different forms. In the drawings, widths, lengths, thicknesses, and the like of elements can be exaggerated for clarity and descriptive purposes. When an element or layer is referred to as being "disposed above" or "disposed on" another element or layer, it can be directly "disposed above" or "disposed on" the other element or layer or intervening elements or layers can be present. Throughout the specification, like reference numerals denote like elements having the same or similar functions.

A light emitting module according to an exemplary embodiment of the present disclosure includes: light emitting diode chips arranged in a plurality of regions on a circuit board, in which the light emitting diode chips are divided into a plurality of light emitting diode groups connected in series, the plurality of light emitting diode groups is connected in parallel to one another, and at least one of the light emitting diode chips in at least one of the groups of light emitting diodes among the plurality of light emitting diode groups is disposed in a region different from that of at least one other light emitting diode chip.

Meanwhile, when the circuit board is equally divided into four, each of divided regions may include at least one light emitting diode chip of each group.

Since a single group of light emitting diode chips connected in series is distributed on the circuit board, even when the group of the light emitting diode chips emit light stronger or weaker than other groups of light emitting diode chips, the light emitting module may provide uniform planar light as a whole.

Meanwhile, the number of light emitting diode chips in each group included in each divided region may be less than or equal to 1/2 of a total number of light emitting diode chips included in each divided region. As such, it is possible to prevent non-uniform light emission by a particular group of light emitting diodes in a particular divided region.

In an exemplary embodiment, each group may include at least 10 equal number of light emitting diode chips. By including at least 10 light emitting diode chips in one group, it is possible to drive the light emitting module while minimizing power loss with a household power source such as 110V or 220V.

In a particular exemplary embodiment, the four divided regions may include a same number of light emitting diode chips with one another.

Furthermore, the light emitting diode chips of each group may be distributed in the same number in the divided regions. As such, uniform light may be emitted from the divided regions.

In an exemplary embodiment, in any square region including a plurality of light emitting diode chips centered on any light emitting diode chip, the number of light emitting diode chips in each group included in the square region may be less than or equal to 1/2 of the total number of light emitting diode chips included in the square region.

Furthermore, in any square region including a plurality of light emitting diode chips centered on any light emitting diode chip, the number of light emitting diode chips in each group included in the square region may be less than or equal to 1/3 of the total number of light emitting diode chips included in the square region.

Meanwhile, the circuit board may have interconnections connecting the light emitting diode chips, and the interconnections may be located on a same plane with one another.

In another exemplary embodiment, the circuit board may have interconnections connecting the light emitting diode chips, and the interconnections may be arranged in a multi-layered structure.

The light emitting diode chips may include at least one Multi Junction Technology light emitting diode (MJT-LED) including a plurality of light emitting cells.

The MJT-LED may include a substrate, and the plurality of light emitting cells may be connected in series to one another on the substrate.

A light emitting module according to another exemplary embodiment of the present disclosure includes: a circuit board; and light emitting diode chips arranged on the circuit board, in which the light emitting diode chips include a first group of light emitting diode chips connected in series with one another and a second group of light emitting diode chips connected in series with one another, the first group of light emitting diode chips and the second group of light emitting diode chips are connected in parallel to one another, and when the circuit board is equally divided into four, each divided region includes at least one light emitting diode chip of the first group and at least one light emitting diode chip of the second group.

Furthermore, the number of light emitting diode chips of the first group in each divided region may be equal to one another, and the number of light emitting diode chips of the second group in each divided region may be also equal to one another.

In addition, the number of light emitting diode chips of the first group and that of light emitting diode chips of the second group in each divided region be equal to each other.

Meanwhile, in any square region including a plurality of light emitting diode chips centered on any light emitting diode chip among the light emitting diode chips of the first and second groups, the number of light emitting diode chips of the first group and that of light emitting diode chips of the second group included in the square region may be less than or equal to 1/2 of the total number of light emitting diode chips included in the square region.

Furthermore, in any one of the square regions of a same size, the number of light emitting diode chips of the first group may be greater than that of light emitting diode chips of the second group.

In addition, in any one of the square regions of the same size, the number of light emitting diode chips of the first group may be less than that of light emitting diode chips of the second group.

A display apparatus according to an exemplary embodiment of the present disclosure includes the light emitting module described above.

The display apparatus may include a plurality of light emitting modules arranged in a matrix.

In addition, a lighting apparatus according to an exemplary embodiment of the present disclosure includes the light emitting module described above.

Hereinafter, various exemplary embodiments of the present disclosure will be described with reference to the drawings.

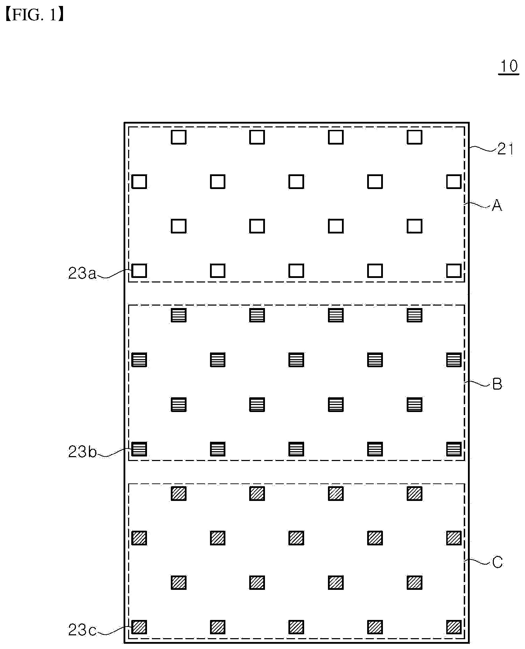

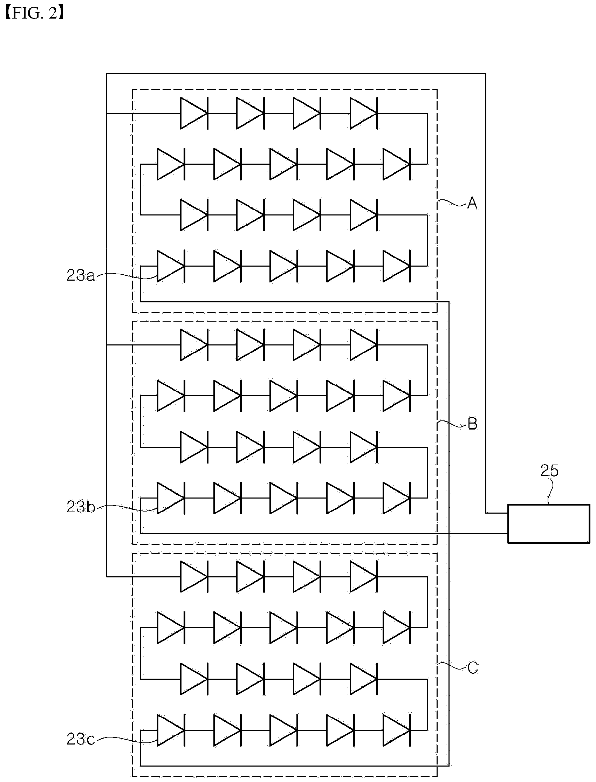

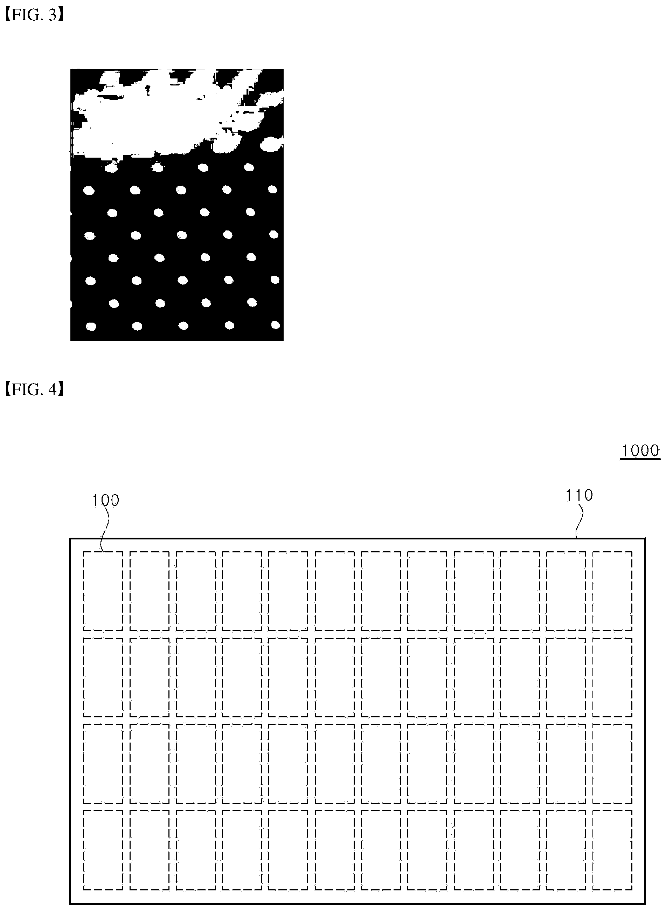

FIG. 1 is a schematic plan view illustrating a light emitting module 10 according to a prior art, FIG. 2 is a schematic circuit diagram of the light emitting module of FIG. 1, and FIG. 3 is an image illustrating a failure of light emitting pattern of the light emitting module according to the prior art.

Referring to FIGS. 1 and 2, the light emitting module 10 includes a circuit board 21 and a plurality of light emitting diode chips 23a, 23b, and 23c.

The circuit board 21 has interconnections for electrically connecting the light emitting diode chips 23a, 23b, and 23c. The light emitting diode chips 23a, 23b, and 23c are mounted on the circuit board 21 and electrically connected to one another by the interconnections.

As shown in the circuit diagram of FIG. 2, the light emitting diode chips 23a, 23b, and 23c include a first group of light emitting diode chips 23a, a second group of light emitting diode chips 23b, and a third group of light emitting diode chips 23, which are connected to one another in series. Furthermore, the first to third groups of light emitting diodes 23a, 23b, and 23c may be connected in parallel to one another to be connected to an external device through a connector 25. Herein, a series connection structure between interconnections and light emitting diode chips is referred to as a string. That is, a series connection structure of the first group of light emitting diode chips is referred to as a first string A, a series connection structure of the second group of light emitting diode chips is referred to as a second string B, and a series connection structure of the third group of the light emitting diode chips is referred to as a third string C.

Referring back to FIG. 1, the first group of light emitting diode chips 23a may be disposed on an upper side of the circuit board 21, the second group of light emitting diode chips 23b may be disposed on a central region of the circuit board 21, and the third group of light emitting diode chips 23c may be disposed on a lower side of the circuit board 21.

When a driving voltage is applied through the connector 25, the driving voltage is equally applied to both ends of the first to third strings. Accordingly, current flows through the first to third groups of light emitting diode chips and light is emitted from the light emitting diode chips. By employing a series-parallel structure, all of the first to third groups of light emitting diode chips may be driven by the driving voltage, thereby simplifying a driving circuit.

Meanwhile, when the first to third strings maintain a same forward voltage, the current is equally divided among the first to third strings, and thus, the light emitting module 10 may generate uniform planar light. However, when any one string has a larger or smaller forward voltage than those of other strings, the current is not uniformly spread.

For example, when a forward voltage of the first string becomes smaller than those of the second and third strings, a voltage applied to the light emitting diode chips 23a in the first string increases, and the current flowing through the first string becomes larger. Accordingly, the light emitting diode chips 23a in the first string may generate more light than the light emitting diode chips 23b and 23c in the other strings.

A difference of the forward voltage between the first to third strings causes a difference of light emission intensity between the light emitting diode chips, and thus, the light emitting module 10 will generate non-uniform light.

FIG. 3 is an image showing that the light emitting diode chips 23a in the first string emit more light than the light emitting diode chips 23b and 23c in the other strings. Since the light emitting diode chips 23a in the first string emit light stronger, an upper region of the light emitting module 10 shines brighter.

There may be several reasons why the forward voltage of one string is different from the forward voltage of the other strings. Even when each string includes a same number of light emitting diode chips, a total forward voltage of any one string may be different from forward voltages of other strings due to a difference in forward voltages of each of the light emitting diode chips. So as to keep the forward voltages of the strings substantially the same, the forward voltages of the strings may be maintained substantially the same by strictly managing product specifications of the light emitting diode chips 23a, 23b, and 23c mounted on the circuit board 21.

However, it is difficult to control performance changes of individual light emitting diode chips according to an operating time of the light emitting module 10. Thus, as the operating time increases, the difference in the forward voltages between the strings is inevitable. The light emitting module according to the prior art cannot prevent light emission non-uniformity caused by the difference in the forward voltages between the strings.

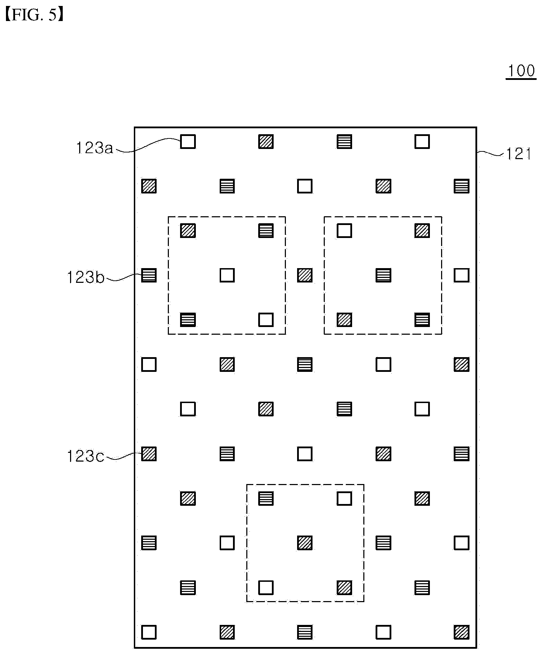

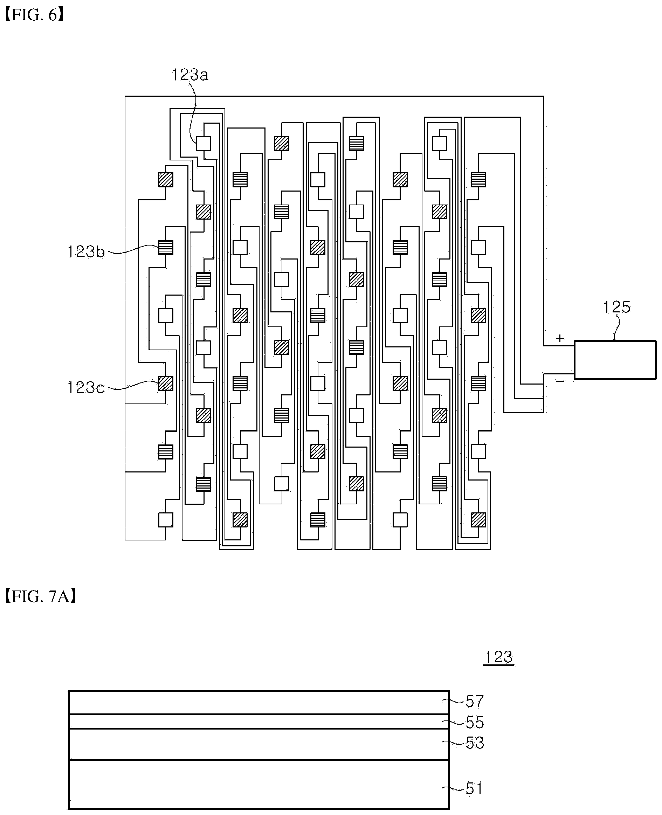

FIG. 4 is a schematic plan view illustrating a display apparatus 1000 according to an exemplary embodiment of the present disclosure, FIG. 5 is a schematic plan view illustrating a light emitting module according to an exemplary embodiment of the present disclosure, and FIG. 6 is a schematic circuit diagram of the light emitting module of FIG. 5.

Referring to FIG. 4, the display apparatus 1000 may include a light emitting module 100 and a display panel 110. For example, the display apparatus 1000 may be a liquid crystal display including a direct backlight unit as the light emitting module 100.

For a large area display, a plurality of light emitting modules 100 may be arranged. Herein, it is illustrated that a total of 48 light emitting modules 100 are arranged, but the inventive concepts are not necessarily limited thereto.

In the illustrated exemplary embodiment, the display apparatus 1000 is exemplarily described as an application product to which the light emitting module 100 is applied, without being limited thereto, but the light emitting module 100 of the present disclosure may also be applied to a lighting apparatus. For example, it may be particularly suitable for being applied to a flat-panel lighting apparatus emitting uniform light.

Referring to FIGS. 5 and 6, the light emitting module 100 includes a circuit board 121 and light emitting diode chips 123a, 123b, and 123c. The circuit board 121 may include interconnections disposed on the same plane or interconnections having a multilayer structure.

The light emitting diode chips 123a, 123b, and 123c may emit light of a similar color or the same color, and for example, may emit white light. The light emitting diode chips may include, for example, a nitride-based light emitting diode and a wavelength converter.

The light emitting diode chips 123a, 123b, and 123c are mounted on the circuit board 121 and are divided into a plurality of groups connected in series by the interconnections. Herein, each group may include a plurality of light emitting diode chips, and for example, may include at least 10 light emitting diode chips. In the illustrated exemplary embodiment, each group includes 18 light emitting diode chips. Each group may include the same number of light emitting diode chips, without being limited thereto. Meanwhile, in the illustrated exemplary embodiment, it is exemplarily described that the light emitting diode chips disposed on the circuit board 121 are divided into three groups, but the inventive concepts are not necessarily limited thereto, and may be divided into two groups, or four or more groups.

Meanwhile, in FIG. 5, the light emitting diode chips belonging to the same group are illustrated as squares having a same shape. For example, the light emitting diode chips 123a illustrated as squares without hatching form a first string as a first group together with interconnections. In addition, the light emitting diode chips 123b in squares filled with parallel hatching form a second string as a second group together with interconnections, and squares filled with diagonal hatching form a third string as a third group together with interconnections.

The light emitting diode chips 123a, 123b, and 123c according to the illustrated exemplary embodiment are different from the light emitting diode chips 23a, 23b, and 23c according to the prior art of FIG. 1 in that they are distributed on the circuit board 121.

For example, the light emitting diode chips 123a of the first group are not disposed within a particular region of the circuit board 121. That is, the light emitting diode chips 123a of the first group are distributed on the circuit board 121. For example, when the circuit board 121 is equally divided into four, each divided region includes at least one light emitting diode chip 123a of the first group. Furthermore, the same number of light emitting diode chips 123a of the first group may be disposed in each divided region. In the illustrated exemplary embodiment, (4 and 1/2) of the light emitting diode chips 123a of the first group are disposed in each divided region.

The light emitting diode chips 123b and 123c of the second group and the third group are also distributed in each divided region of the circuit board 121. Like the first group, a same number of light emitting diode chips 123b of the second group may be disposed in each divided region, and a same number of light emitting diode chips 123c of the third group may be disposed in each divided region.

Meanwhile, the number of light emitting diode chips in each group included in each divided region may be less than or equal to 1/2 of a total number of light emitting diode chips included in each divided region. As such, uniform light may be emitted from the respective divided regions.

In some exemplary embodiments, the number of the light emitting diode chips 123a of the first group disposed in a particular divided region may be equal to the number of the light emitting diode chips 123b of the second group and/or that of the light emitting diode chips 123c of the third group disposed in the same divided region.

Furthermore, in any square region (indicated by a dotted line in FIG. 5) including a plurality of light emitting diode chips centered on any light emitting diode chip, the number of light emitting diode chips in each group included in the square region may be less than or equal to 1/2 of the total number of light emitting diode chips included in the square region.

For example, in FIG. 5, in a square region indicated by the dotted line including five light emitting diode chips centered on the light emitting diode chip 123a, two light emitting diode chips 123a of the first group, two light emitting diode chips 123b of the second group, and one light emitting diode chip 123c of the third group are included. In the square region indicated by the dotted line including five light emitting diode chips centered on the light emitting diode chip 123b, one light emitting diode chip 123a of the first group, two light emitting diode chips 123b of the second group, and two light emitting diode chips 123c of the third group are also included. In a square region indicated by the dotted line including five light emitting diode chips centered on the light emitting diode chip 123c, two light emitting diode chips 123a of the first group, one light emitting diode chip 123b of the second group, and two light emitting diode chips 123c of the third group are included. The number of the light emitting diode chips of any group does not exceed 1/2 of the total number of light emitting diode chips included in the square region.

For a particular exemplary embodiment including at least four groups, in any square region including a plurality of light emitting diode chips centered on any light emitting diode chip, the number of light emitting diode chips in each group included in a square region may be less than or equal to 1/3 of the total number of light emitting diode chips included in the square region.

As such, by arranging the light emitting diode chips 123a, 123b, and 123c on the circuit board 121 as described above, it is possible to prevent generation of non-uniform light in a particular region.

Furthermore, it can be seen that in the light emitting module 100 of FIG. 5, three or more light emitting diode chips of the same group are not continuously arranged in any direction. In particular, at least one of the light emitting diode chips 123a, 123b, and 123c of each group is disposed in the same row, and in each row, the number of the light emitting diode chips of any group in each row does not exceed 1/2 of the total number of the light emitting diode chips in the row.

Meanwhile, as shown in FIG. 6, the light emitting diode chips 123a, 123b, and 123c of FIG. 5 may be electrically connected to one other using interconnections disposed on the same plane of the circuit board 121. However, the inventive concepts are not limited thereto, and interconnections having a multilayer structure may be used.

The interconnections may be connected to a connector 125, and power may be supplied to the light emitting module 100 from an external power source through the connector 125.

Meanwhile, the light emitting diode chips 123a, 123b, and 123c may have the same structure as described above. Hereinafter, the structure of the light emitting diode chip will be described.

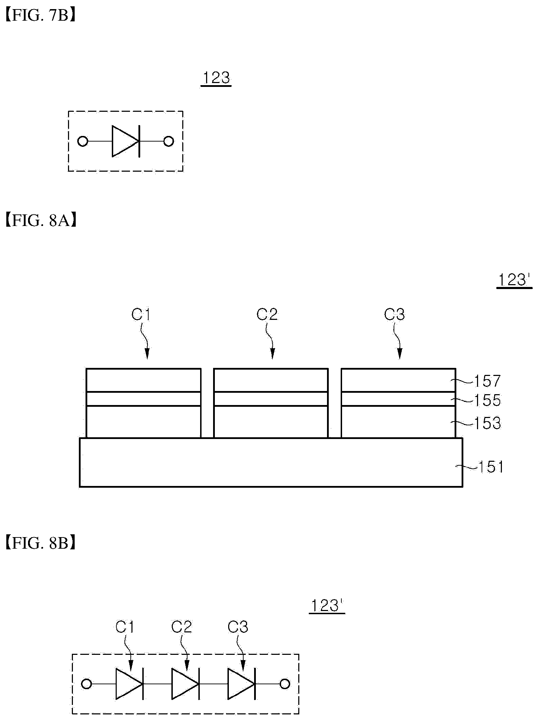

FIG. 7A and FIG. 7B are a schematic cross-sectional view and a circuit diagram illustrating a light emitting diode chip 123 arranged in the light emitting module according to an exemplary embodiment of the present disclosure, respectively.

Referring to FIG. 7A and FIG. 7B, the light emitting diode chip 123 may include a substrate 51, a first conductivity type semiconductor layer 53, an active layer 55, and a second conductivity type semiconductor layer 57. Furthermore, the light emitting diode chip 123 may include a wavelength converter (not shown) for converting a wavelength of light generated in the active layer 55.

The substrate 51 is not particularly limited as long as it is a substrate capable of supporting the semiconductor layers 53, 55, and 57. In particular, the substrate 51 may be a growth substrate used to grow the semiconductor layers 53, 55, and 57. For example, the substrate 51 may be a sapphire substrate, a gallium nitride substrate, a silicon carbide substrate, or a silicon substrate.

Meanwhile, the first conductivity type semiconductor layer 53, the active layer 55, and the second conductivity type semiconductor layer 57 may include a III-V series nitride-based semiconductor, and may include a nitride-based semiconductor such as (Al, Ga, In )N for example. The first conductivity type semiconductor layer 53 may include an n-type impurity (e.g., Si, Ge, or Sn), and the second conductivity type semiconductor layer 57 may include a p-type impurity (e.g., Mg, Mg, Sr, or Ba). Alternatively, it may be vice versa. The active layer 55 may include a multiple quantum well structure (MQW), and a composition ratio of the nitride-based semiconductor may be adjusted to emit a desired wavelength. In particular, in the illustrated exemplary embodiment, the second conductivity type semiconductor layer 57 may be the p-type semiconductor layer.

The light emitting diode chip 123 may have various structures such as a horizontal type, a vertical type, a flip chip type, or the like. The wavelength converter is disposed on a path of light generated in the active layer 55 to convert the wavelength of light. The wavelength converter may be disposed on the substrate 51 side or the second conductivity type semiconductor layer 57 side depending on the structure of the light emitting diode chip 123.

Meanwhile, in the illustrated exemplary embodiment, the light emitting diode chip 123 includes a light emitting structure of a single cell, and thus, as shown in FIG. 7B, a single diode is disposed between both ends. However, the inventive concepts are not limited to the single cell light emitting diode, and may include diodes of a plurality of cells. This will be described with reference to FIG. 8A and FIG. 8B.

FIG. 8A and FIG. 8B are a schematic cross-sectional view and a circuit diagram illustrating a light emitting diode chip 123' arranged in a light emitting module according to another exemplary embodiment of the present disclosure, respectively.

Referring to FIGS. 8A and 8B, a light emitting diode chip 123' includes a substrate 151 and a plurality of cells C1, C2, and C3. Each of the cells C1, C2, and C3 includes a first conductivity type semiconductor layer 153, an active layer 155, and a second conductivity type semiconductor layer 157.

Since the substrate 151 is similar to the substrate 51 described above, a detailed description thereof will be omitted to avoid redundancy. In addition, since the first conductivity type semiconductor layer 153, the active layer 155, and the second conductivity type semiconductor layer 157 are also the same as those described with reference to FIG. 7A, detailed descriptions thereof will be omitted.

The plurality of light emitting cells C1. C2, and C3 is disposed on the substrate 151, and as shown in FIG. 8B, they are connected in series with one another. Such a light emitting diode chip is referred to as a Multi Junction Technology light emitting diode (MJT-LED). Although three light emitting cells C1, C2, and C3 are shown in FIGS. 8A and 8B, without being limited thereto, but two or four or more light emitting cells may be included.

In an MJT-LED including a plurality of light emitting cells, even when leakage occurs in any one of the light emitting cells, a forward voltage of entire strings may be affected.

Meanwhile, a wavelength converter (not shown) may be arranged to convert a wavelength of light generated from the light emitting cells C1, C2, and C3. The wavelength converter may be disposed on the substrate side or the second conductivity type semiconductor layer side.

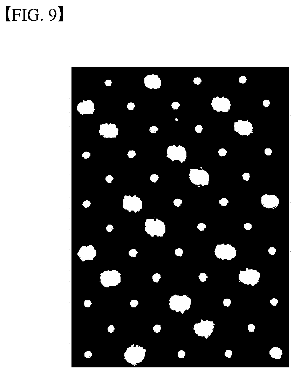

FIG. 9 is an image illustrating a failure of light emitting pattern of the light emitting module according to an exemplary embodiment of the present disclosure.

Referring to FIG. 9, in the light emitting module 100 of FIG. 5, the light emitting diode chips 123c of the third group emit light stronger than the light emitting diode chips 123a and 123b of the other groups. This may be because the forward voltage of the third string including the third group of light emitting diode chips 123c is smaller than the forward voltages of the first and second strings for some reason.

As the light emitting diode chips 123c in the third string emit light stronger, the light emitting diode chips 123a, 123b, and 123c emit non-uniform light with one another. However, according to the illustrated exemplary embodiment, since the light emitting diode chips 123c in the third string are uniformly distributed on the circuit board 121, the light emitting module 100 may emit uniform planar light as a whole.

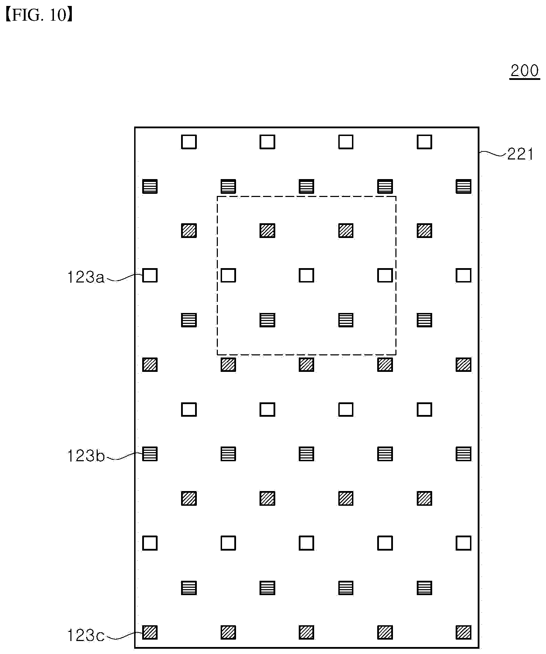

FIG. 10 is a schematic plan view illustrating a light emitting module 200.

Referring to FIG. 10, the light emitting module 200 according to the present embodiment is substantially similar to the light emitting module 100 described with reference to FIG. 5, except that an arrangement of light emitting diode chips 123a, 123b, and 123c is different.

In the illustrated exemplary embodiment, the light emitting diode chips 123a, 123b, or 123c belonging to the same group are arranged in a same row. However, one row of light emitting diode chips belonging to a different group is disposed between adjacent rows of light emitting diode chips belonging to the same group. For example, as shown in FIG. 10, when the first to third groups of light emitting diode chips 123a, 123b, and 123c are arranged on a circuit board 221, a row of the second group of light emitting diode chips 123b and a row of the third group of light emitting diode chips 123c are disposed between rows of light emitting diode chips 123a belonging to the first group. An order of the rows may be repeated regularly. For example, as shown in FIG. 10, the rows may be repeated in the order of the first group-second group-third group-first group-second group-third group.

According to the illustrated exemplary embodiment, even when the light emitting diode chips in a particular string emit light stronger, since the light emitting diode chips are distributed on the circuit board 221, the light emitting module 200 may realize uniform light.

In the above exemplary embodiment, the light emitting modules according to various exemplary embodiments of the present disclosure has been described, but the inventive concepts are not limited to the above exemplary embodiments and may be variously modified. In addition, the above-described light emitting modules may be used as a light source emitting uniform planar light in a display apparatus such as a liquid crystal display or a lighting apparatus.

## Claims

1. A light emitting module (100), comprising:
a circuit board (121); and
light emitting diode chips (123a, 123b, 123c) arranged in a plurality of regions on the circuit board (121), wherein:
the light emitting diode chips (123a, 123b, 123c) are divided into a plurality of light emitting diode groups, the light emitting diode chips (123a, 123b, 123c) belonging to a same light emitting diode group are connected in series, and the plurality of light emitting diode groups is connected in parallel to one another,
at least one of the light emitting diode chips (123a, 123b, 123c) in each of the plurality of light emitting diode groups is disposed in a region different from that of at least one other light emitting diode chip of the corresponding light emitting diode group of the plurality of light emitting diode groups,
wherein the light emitting diode chips (123a, 123b, 123c) are arranged such that three or more light emitting diode chips of a same light emitting diode group are not continuously arranged in any direction.

2. The light emitting module (100) of claim 1,
wherein, when the circuit board (121) is equally divided into four, each divided region includes at least one light emitting diode chip of each group.

3. The light emitting module (100) of claim 2,
wherein the number of light emitting diode chips (123a, 123b, 123c) in each group included in each divided region is less than or equal to 1/2 of a total number of light emitting diode chips included in each divided region.

4. The light emitting module (100) of claim 2,
wherein each group includes at least 10 equal number of light emitting diode chips.

5. The light emitting module (100) of claim 2,
wherein the four divided regions include a same number of light emitting diode chips with one another.

6. The light emitting module (100) of claim 5,
wherein the light emitting diode chips (123a, 123b, 123c) of each group are distributed in the same number in the divided regions.

7. The light emitting module (100) of claim 2,
wherein, in any square region including a plurality of light emitting diode chips centered on any light emitting diode chip, the number of light emitting diode chips in each group included in the square region is less than or equal to 1/2 of the total number of light emitting diode chips included in the square region.

8. The light emitting module (100) of claim 7,
wherein, in any square region including a plurality of light emitting diode chips centered on any light emitting diode chip, the number of light emitting diode chips in each group included in the square region is less than or equal to 1/3 of the total number of light emitting diode chips included in the square region.

9. The light emitting module (100) of claim 2, wherein:
the circuit board (121) has interconnections connecting the light emitting diode chips, and
the interconnections are located on a same plane with one another.

10. The light emitting module (100) of claim 2, wherein:
the circuit board (121) has interconnections connecting the light emitting diode chips, and
the interconnections are arranged in a multi-layered structure.

11. The light emitting module (100) of claim 2,
wherein the light emitting diode chips (123a, 123b, 123c) include at least one MJT-LED including a plurality of light emitting cells.

12. The light emitting module (100) of claim 11, wherein:
the MJT-LED includes a substrate, and
the plurality of light emitting cells is connected in series to one another on the substrate.

13. A light emitting module (100), comprising:
a circuit board (121); and
light emitting diode chips (123a, 123b, 123c) arranged on the circuit board (121), wherein:
the light emitting diode chips (123a, 123b, 123c) include a first group of light emitting diode chips connected in series with one another and a second group of light emitting diode chips connected in series with one another,
the first group of light emitting diode chips and the second group of light emitting diode chips are connected in parallel to one another, and
when the circuit board (121) is equally divided into four, each divided region includes at least one light emitting diode chip of the first group and at least one light emitting diode chip of the second group.

14. A display apparatus comprising the light emitting module of claim 1 to claim 13.

15. The display apparatus of claim 14, comprising:
a plurality of light emitting modules arranged in a matrix.

## Patentansprüche

1. Leuchtmodul (100), umfassend:
eine Leiterplatte (121); und
Leuchtdiodenchips (123a, 123b, 123c), die in mehreren Regionen auf der Leiterplatte (121) angeordnet sind, wobei:
die Leuchtdiodenchips (123a, 123b, 123c) in mehrere Leuchtdiodengruppen unterteilt sind, die zu einer selben Leuchtdiodengruppe gehörenden Leuchtdiodenchips (123a, 123b, 123c) in Reihe geschaltet sind, und die mehreren Leuchtdiodengruppen parallel zueinander geschaltet sind,
mindestens einer der Leuchtdiodenchips (123a, 123b, 123c) in jeder der mehreren Leuchtdiodengruppen in einer Region angeordnet ist, die sich von derjenigen mindestens eines anderen Leuchtdiodenchips der entsprechenden Leuchtdiodengruppe der mehreren Leuchtdiodengruppen unterscheidet,
wobei die Leuchtdiodenchips (123a, 123b, 123c) so angeordnet sind, dass drei oder mehr Leuchtdiodenchips einer selben Leuchtdiodengruppe in keiner Richtung kontinuierlich angeordnet sind.

2. Leuchtmodul (100) nach Anspruch 1,
wobei, wenn die Leiterplatte (121) gleichmäßig geviertelt ist, jede unterteilte Region mindestens einen Leuchtdiodenchip jeder Gruppe aufweist.

3. Leuchtmodul (100) nach Anspruch 2,
wobei die Anzahl von Leuchtdiodenchips (123a, 123b, 123c) in jeder Gruppe, die in jeder unterteilten Region vorhanden ist, kleiner als oder gleich 1/2 einer Gesamtzahl von Leuchtdiodenchips ist, die in jeder unterteilten Region vorhanden sind.

4. Leuchtmodul (100) nach Anspruch 2,
wobei jede Gruppe mindestens 10 gleich viele Leuchtdiodenchips aufweist.

5. Leuchtmodul (100) nach Anspruch 2,
wobei die vier unterteilten Regionen jeweils eine gleiche Anzahl von Leuchtdiodenchips aufweisen.

6. Leuchtmodul (100) nach Anspruch 5,
wobei die Leuchtdiodenchips (123a, 123b, 123c) jeder Gruppe in der gleichen Anzahl in den unterteilten Regionen verteilt sind.

7. Leuchtmodul (100) nach Anspruch 2,
wobei in jeder beliebigen quadratischen Region, die mehrere Leuchtdiodenchips aufweist, die auf einem beliebigen Leuchtdiodenchip zentriert sind, die Anzahl von Leuchtdiodenchips in jeder Gruppe, die in der quadratischen Region vorhanden sind, kleiner als oder gleich 1/2 der Gesamtzahl von Leuchtdiodenchips ist, die in der quadratischen Region vorhanden sind.

8. Leuchtmodul (100) nach Anspruch 7,
wobei in jeder beliebigen quadratischen Region, die mehrere Leuchtdiodenchips aufweist, die auf einem beliebigen Leuchtdiodenchip zentriert sind, die Anzahl von Leuchtdiodenchips in jeder Gruppe, die in der quadratischen Region vorhanden sind, kleiner als oder gleich 1/3 der Gesamtzahl von Leuchtdiodenchips ist, die in der quadratischen Region vorhanden sind.

9. Leuchtmodul (100) nach Anspruch 2, wobei:
die Leiterplatte (121) Verbindungen aufweist, die die Leuchtdiodenchips verbinden, und
die Verbindungen jeweils auf einer selben Ebene zueinander angeordnet sind.

10. Leuchtmodul (100) nach Anspruch 2, wobei:
die Leiterplatte (121) Verbindungen aufweist, die die Leuchtdiodenchips verbinden, und
die Verbindungen in einer mehrschichtigen Struktur angeordnet sind.

11. Leuchtmodul (100) nach Anspruch 2,
wobei die Leuchtdiodenchips (123a, 123b, 123c) mindestens eine MJT-LED aufweisen, die mehrere Leuchtzellen aufweist.

12. Leuchtmodul (100) nach Anspruch 11, wobei:
die MJT-LED ein Substrat aufweist, und
die mehreren Leuchtzellen auf dem Substrat miteinander in Reihe geschaltet sind.

13. Leuchtmodul (100), umfassend:
eine Leiterplatte (121); und
Leuchtdiodenchips (123a, 123b, 123c), die auf der Leiterplatte (121) angeordnet sind, wobei:
die Leuchtdiodenchips (123a, 123b, 123c) eine erste Gruppe von Leuchtdiodenchips aufweisen, die miteinander in Reihe geschaltet sind, und eine zweite Gruppe von Leuchtdiodenchips aufweisen, die miteinander in Reihe geschaltet sind,
die erste Gruppe von Leuchtdiodenchips und die zweite Gruppe von Leuchtdiodenchips zueinander parallel geschaltet sind, und
wenn die Leiterplatte (121) gleichmäßig geviertelt ist, jede unterteilte Region mindestens einen Leuchtdiodenchip der ersten Gruppe und mindestens einen Leuchtdiodenchip der zweiten Gruppe aufweist.

14. Anzeigevorrichtung, umfassend das Leuchtmodul nach Anspruch 1 bis Anspruch 13.

15. Anzeigevorrichtung nach Anspruch 14, umfassend:
mehrere Leuchtmodule, die in einer Matrix angeordnet sind.

## Revendications

1. Module électroluminescent (100), comprenant :
une carte de circuit imprimé (121) ; et
des puces à diode électroluminescente (123a, 123b, 123c) disposées dans une pluralité de régions sur la carte de circuit imprimé (121), dans lequel :
les puces à diode électroluminescente (123a, 123b, 123c) sont divisées en une pluralité de groupes de diodes électroluminescentes, les puces à diode électroluminescente (123a, 123b, 123c) appartenant à un même groupe de diodes électroluminescentes sont connectées en série, et la pluralité de groupes de diodes électroluminescentes sont connectés en parallèle les uns aux autres,
au moins l'une des puces à diode électroluminescente (123a, 123b, 123c) dans chacun de la pluralité de groupes de diodes électroluminescentes est disposée dans une région différente de celle d'au moins une autre puce à diode électroluminescente du groupe de diodes électroluminescentes correspondant de la pluralité de groupes de diodes électroluminescentes,
dans lequel les puces à diode électroluminescente (123a, 123b, 123c) sont disposées de telle sorte que trois puces à diode électroluminescente ou plus d'un même groupe de diodes électroluminescentes ne sont pas disposées de manière continue dans une quelconque direction.

2. Module électroluminescent (100) selon la revendication 1,
dans lequel, lorsque la carte de circuit imprimé (121) est divisée de manière égale en quatre, chaque région divisée comporte au moins une puce à diode électroluminescente de chaque groupe.

3. Module électroluminescent (100) selon la revendication 2,
dans lequel le nombre de puces à diode électroluminescente (123a, 123b, 123c) dans chaque groupe inclus dans chaque région divisée est inférieur ou égal à 1/2 d'un nombre total de puces à diode électroluminescente incluses dans chaque région divisée.

4. Module électroluminescent (100) selon la revendication 2,
dans lequel chaque groupe comporte au moins 10 puces à diode électroluminescente en nombre égal.

5. Module électroluminescent (100) selon la revendication 2,
dans lequel les quatre régions divisées comportent un même nombre de puces à diode électroluminescente les unes par rapport aux autres.

6. Module électroluminescent (100) selon la revendication 5,
dans lequel les puces à diode électroluminescente (123a, 123b, 123c) de chaque groupe sont réparties dans le même nombre dans les régions divisées.

7. Module électroluminescent (100) selon la revendication 2,
dans lequel, dans toute région carrée comportant une pluralité de puces à diode électroluminescente centrées sur une puce à diode électroluminescente quelconque, le nombre de puces à diode électroluminescente dans chaque groupe inclus dans la région carrée est inférieur ou égal à 1/2 du nombre total de puces à diode électroluminescente incluses dans la région carrée.

8. Module électroluminescent (100) selon la revendication 7,
dans lequel, dans toute région carrée comportant une pluralité de puces à diode électroluminescente centrées sur une puce à diode électroluminescente quelconque, le nombre de puces à diode électroluminescente dans chaque groupe inclus dans la région carrée est inférieur ou égal à 1/3 du nombre total de puces à diode électroluminescente incluses dans la région carrée.

9. Module électroluminescent (100) selon la revendication 2, dans lequel :
la carte de circuit imprimé (121) possède des interconnexions reliant les puces à diode électroluminescente, et
les interconnexions sont situées sur un même plan les unes par rapport aux autres.

10. Module électroluminescent (100) selon la revendication 2, dans lequel :
la carte de circuit imprimé (121) possède des interconnexions reliant les puces à diode électroluminescente, et
les interconnexions sont disposées dans une structure multicouche.

11. Module électroluminescent (100) selon la revendication 2,
dans lequel les puces à diode électroluminescente (123a, 123b, 123c) comportent au moins une LED MJT comportant une pluralité de cellules électroluminescentes.

12. Module électroluminescent (100) selon la revendication 11, dans lequel :
la LED MJT comporte un substrat, et
la pluralité de cellules électroluminescentes sont connectées en série les unes aux autres sur le substrat.

13. Module électroluminescent (100), comprenant :
une carte de circuit imprimé (121) ; et
des puces à diode électroluminescente (123a, 123b, 123c) disposées sur la carte de circuit imprimé (121), dans lequel :
les puces à diode électroluminescente (123a, 123b, 123c) comportent un premier groupe de puces à diode électroluminescente connectées en série les unes avec les autres et un second groupe de puces à diode électroluminescente connectées en série les unes avec les autres,
le premier groupe de puces à diode électroluminescente et le second groupe de puces à diode électroluminescente sont connectés en parallèle l'un à l'autre, et
lorsque la carte de circuit imprimé (121) est divisée de manière égale en quatre, chaque région divisée comporte au moins une puce à diode électroluminescente du premier groupe et au moins une puce à diode électroluminescente du second groupe.

14. Appareil d'affichage comprenant le module électroluminescent selon la revendication 1 à la revendication 13.

15. Appareil d'affichage selon la revendication 14, comprenant :
une pluralité de modules électroluminescents disposés en matrice.
